(19) Europäisches Patentamt
European Patent Office
Office européen des brevets

(11) **EP 3 596 622 B1**

(12) **FASCICULE DE BREVET EUROPEEN**

(45) Date de publication et mention de la délivrance du brevet:
**11.10.2023 Bulletin 2023/41**

(21) Numéro de dépôt: **18709377.8**

(22) Date de dépôt: **14.03.2018**

(51) Classification Internationale des Brevets (IPC):
**G06F 30/15** (2020.01)    **B64G 1/14** (2006.01)
**B64G 1/00** (2006.01)    **B64G 1/64** (2006.01)
**B64G 1/22** (2006.01)    **G06F 17/12** (2006.01)

(52) Classification Coopérative des Brevets (CPC):
**G06F 17/12; B64G 1/002; B64G 1/228; B64G 1/641; B64G 1/643;** G06F 30/15; G06F 30/23

(86) Numéro de dépôt international:
**PCT/EP2018/056421**

(87) Numéro de publication internationale:
**WO 2018/167161 (20.09.2018 Gazette 2018/38)**

(54) **PROCÉDÉ D'ANALYSE D'UN SYSTÈME COUPLÉ VÉHICULE/PASSAGER**

VERFAHREN ZUR ANALYSE EINES GEKOPPELTEN FAHRZEUG-/INSASSENSYSTEMS

METHOD FOR ANALYSING A COUPLED VEHICLE/PASSENGER SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.03.2017 FR 1752085**

(43) Date de publication de la demande:
**22.01.2020 Bulletin 2020/04**

(73) Titulaire: **Centre National d'Etudes Spatiales 75001 Paris (FR)**

(72) Inventeur: **GONIDOU, Luc-Olivier 91590 Baulne (FR)**

(74) Mandataire: **Germain Maureau 12, rue Boileau 69006 Lyon (FR)**

(56) Documents cités:
- H. J.-P. MORAND: "Prévision de l'ambiance vibratoire des satellites", 3E COLLOQUE TENDANCES ACTUELLES EN CALCUL DE STRUCTURES, 1985, pages 197-214, XP055433757, Bastia, Corse cité dans la demande

- YUAN ZHAO XU ET AL: "Finite element model updating of damped structures using vibration test data under base excitation", JOURNAL OF SOUND AND VIBRATION, vol. 340, 19 décembre 2014 (2014-12-19), pages 303-316, XP029188321, ISSN: 0022-460X, DOI: 10.1016/J.JSV.2014.11.041

- STARC BLAZ ET AL: "A mixed-contact formulation for a dynamics simulation of flexible systems: An integration with model-reduction techniques", JOURNAL OF SOUND AND VIBRATION, vol. 393, 19 janvier 2017 (2017-01-19), pages 145-156, XP029916057, ISSN: 0022-460X, DOI: 10.1016/J.JSV.2017.01.026

- LIU ET AL: "Parameter analysis of PAF for whole-spacecraft vibration isolation", AEROSPACE SCIENCE AND TECHNOLOGY, ELSEVIER MASSON, FR, vol. 11, no. 6, 19 juillet 2007 (2007-07-19), pages 464-472, XP022158287, ISSN: 1270-9638, DOI: 10.1016/J.AST.2007.02.006

- DE KLERK D ET AL: "General framework for dynamic substructuring: History, review, and classification of techniques", AIAA JOURNAL, AIAA - THE AMERICAN INSTITUTE OF AERONAUTICS AND ASTRONAUTICS, US , vol. 46, no. 5 mai 2008 (2008-05), pages 1169-1181, XP002695579, ISSN: 0001-1452, DOI: 10.2514/1.33274 Extrait de l'Internet: URL:http://arc.aiaa.org/doi/abs/10.2514/1. 33274 [extrait le 2017-12-11]

EP 3 596 622 B1

- **DICKENS J M ET AL: "Coupled Loads Analysis Accuracy from the Space Vehicle Perspective", ACTA ASTRONAUTICA, PERGAMON PRESS, ELMSFORD, GB, vol. 48, no. 1, 2001, pages 21-28, XP027475833, ISSN: 0094-5765, DOI: 10.1016/S0094-5765(00)00122-3 [extrait le 2001-01-01]**
- **Schotte Jean-Sebastien ET AL: "Effect of internal liquids on the vibrations of aerospace structures", , 14 February 2012 (2012-02-14), XP093043699, Retrieved from the Internet: URL:https://arc.aiaa.org/doi/10.2514/6.2012-1887>**

**Description**

DOMAINE TECHNIQUE GENERAL ET ETAT DE LA TECHNIQUE

L'invention concerne un procédé de calcul de réponses vibratoires d'un système couplé véhicule/passager, le véhicule étant notamment un lanceur spatial adapté pour transporter un ou plusieurs satellites. Les forces extérieures ne s'appliquant que sur le véhicule.

ETAT DE LA TECHNIQUE

L'analyse d'un système couplé véhicule/passager, tel qu'un lanceur spatial transportant une charge utile (un ou plusieurs satellite(s)) afin de déterminer son comportement/ambiance vibratoire est cruciale durant les études de développement d'un nouveau lanceur et durant sa phase d'exploitation.

En particulier, durant le lancement, le lanceur est soumis à d'importantes forces extérieures qui peuvent être dommageables pour le lanceur ou les charges utiles.

Ainsi, en fonction de la charge utile, les réponses vibratoires du lanceur et de la charge utile sont déterminées.

L'obtention de ces réponses est longue et fastidieuse sachant que ces réponses doivent être obtenues pour chaque charge utile avant chaque lancement.

Afin de limiter les temps de calcul, on utilise un procédé d'analyse mettant en oeuvre une réanalyse. En particulier, il s'agit de déterminer une ambiance vibratoire du lanceur et d'une charge utile de référence et, à partir de ces réponses obtenues, de déterminer l'ambiance vibratoire du couple : autre charge utile et du lanceur. Le lanceur étant identique, la charge utile non. L'ambiance vibratoire de référence est déterminée de manière standard.

Une telle méthode est décrite dans le document : P.A. Blelloch, C.C. Flanigan, « A time domain approach for spacecraft reanalysis », AIAA journal n°92-2517-CP ou dans Christophe Berthod. Identification paramétrique de grandes structures : réanalyse et méthode évolutionnaire. Mécanique [physics.med-ph]. Université de Franche-Comté, 1998. Toutefois cette méthode approchée repose sur une procédure de Rayleigh-Ritz utilisant une base modale classique ou enrichie qui conduit à un système comportant une matrice de masse singulière. Cette singularité doit être supprimée en utilisant une approche de type SVD coûteuse en temps et le résultat obtenu ne peut pas être garanti.

Une autre méthode est décrite dans le document : H. J.-P. Morand et al, « Prévision de l'ambiance vibratoire des satellites », Tendances actuelles en calcul de structures, Bastia 6-7-8 novembre 1985. Toutefois, cette méthode présente les mêmes problèmes de singularité que la précédente car elle intègre une projection sur une base modale classique et ne permet pas d'obtenir de nouvelles réponses vibratoires sur le lanceur sans refaire un calcul classique pour chaque nouvelle configuration. Il est connnu de l'état de l'art les documents:

XP055433757 "Prévision de l'ambiance vibratoire des satellites" publié en 1985 auteurs MORAND H J P; LE GOARANT M; BODAGALA P R; CHEMOUL B qui décrit la technique des fonctions de transfert pour formuler d"une manière générale le problème de réponse dynamique couplée lanceur/charge utile. Ce document décrit ensuite les algorithmes de "résolution fréquentielle" mis au point dans le cas de couplages de type axial ou de flexion, puis une méthode générale de "résolution temporelle" utilisant des forces extérieures équivalentes.

XP093043699 "Effect of internal liquids on the vibrations of aerospace structures" publié le 14-06-2012 auteurs Schotte Jean-Sebastien, . Miras And Roger Ohayon.

XP029188321 "Finite element model updating of damped structures using vibration test data under base excitation" publié le 19-12-2014 auteurs Yuan Zhao Xu; Yu Kai Ping

PRESENTATION DE L'INVENTION

Un but de l'invention est d'améliorer les procédés d'analyse mettant en oeuvre une réanalyse.

En particulier, l'invention propose une amélioration de la méthode originelle de MORAND, présentée en introduction.

A ce titre, la méthode de l'invention repose sur l'utilisation d'une ambiance vibratoire de référence relative à un véhicule et un passager de référence obtenue de manière standard pour obtenir l'ambiance vibratoire relative au véhicule et à un nouveau passager.

Pour ce faire, une méthode de réanalyse, du type MORAND est mise en oeuvre, l'invention mettant avantageusement en oeuvre cette méthode avec une approche directe au lieu d'une approche modale pour déterminer les différents opérateurs.

En effet, le Demandeur a identifié de façon avantageuse que la méthode modale utilisée pour calculer les opérateurs dans MORAND conduisait à avoir une troncature qui diminuait la dimension du système de référence et induisait par la suite des matrices singulières. Le gain de temps apporté par la méthode de MORAND repose sur la diminution de la taille du système à résoudre (passage du nombre de ddls du système de référence au nombre de ddls d'interface véhicule/passager) et n'est pas lié à une formulation modale comme la méthode de Blelloch et Flanigan. Avec cette approche, il est donc possible de diminuer la taille du système sans modifier sa dimension.

Aussi, pour améliorer la méthode de MORAND et comme jamais suggéré, le Demandeur met en oeuvre le calcul des différents opérateurs utilisés non pas en utilisant une projection sur une base modale classique mais de manière directe.

Ainsi, l'invention propose, selon un premier aspect, un procédé mis en oeuvre par ordinateur, pour le contrôle d'une compatibilité mécanique entre un passager et un véhicule par la détermination par réanalyse d'une ambiance vibratoire d'un système couplé comprenant le véhicule et le passager le véhicule étant soumis à des efforts extérieurs Fext et étant couplé à un nouveau passager comprenant x=1,..., N charge(s) utile(s), au niveau d'interfaces Ix véhicule/passager,

procédé le procédé étant caractérisé en ce qu'il comprend une étape DET1) de détermination, à partir d'accélération(s) interfaciale(s) $\gamma_{x\_ref}$ de référence d'un passager de référence, d'accélération(s) interfaciale(s) $\gamma'_x$ relatives au nouveau passager au moyen de la relation suivante

$$\gamma'_x(\omega) = \left\{ I + M_{REF}^{TOT^{-1}}(\omega)\Delta M_x^P(\omega) \right\}^{-1} . \gamma_{x\_ref}(\omega)$$

avec

- $\gamma_{xref}(\omega)$ : vecteur des accélérations sur tous les degrés de liberté de l'interface véhicule/passager pour le passager de référence ;
- $\gamma'_x(\omega)$ : vecteur des accélérations sur tous les degrés de liberté de l'interface véhicule/passager pour le nouveau passager ;

$$\Delta M_x^P(\omega) = M_x^P(\omega) - M_{ref}^P(\omega) ;$$

- $M_x^P(\omega)$ : l'opérateur de masse dynamique d'interface du nouveau passager ;
- $M_{ref}^P(\omega)$ : l'opérateur de masse dynamique d'interface du passager de référence ;
- $M_{REF}^{TOT}(\omega)$ : l'opérateur de masse dynamique d'interface du véhicule couplé au passager de référence ;

les opérateurs $M_x^P(\omega)$, $M_{ref}^P(\omega)$ et $M_{REF}^{TOT}(\omega)$ étant obtenus par une approche directe de la manière suivante :

$$\frac{1}{-\omega^2} \left\{ \begin{array}{c} \left(-\omega^2 M_{jj} + j\omega C_{jj} + K_{jj} + jH_{jj}\right) + \\ \left(-\omega^2 M_{ji} + j\omega C_{ji} + K_{ji} + jH_{ji}\right)\left(-\omega^2 M_{ii} + j\omega C_{ii} + K_{ii} + jH_{ii}\right)^{-1}\left(\omega^2 M_{ij} + j\omega C_{ij} + K_{ij} + jH_{ij}\right) \end{array} \right\}$$

- M matrice de masse du passager de référence, du nouveau passager ou du véhicule couplé au passager de référence ;
- K matrice de rigidité du passager de référence, du nouveau passager ou du véhicule couplé au passager de référence ;
- C matrice d'amortissement visqueux du passager de référence, du nouveau passager ou du véhicule couplé au passager de référence ;
- H matrice de d'amortissement hystérétique du passager de référence, du nouveau passager ou du véhicule couplé au passager de référence ;
- I : la matrice identité.

L'invention est avantageusement complétée par les caractéristiques suivantes, prises seules ou en une quelconque de leur combinaison techniquement possible :

- Le procédé comprend en outre les étapes suivantes

DET2) détermination d'une première réponse vibratoire du véhicule seul, encastré sur tous les degrés de libertés de l'interface véhicule/passager et soumis aux efforts extérieurs Fext ;

DET3) détermination d'une seconde réponse vibratoire $\gamma V_2$ du véhicule soumis à l'accélération interfaciale du passager ;

DET4) détermination à partir, des première et seconde réponses vibratoires $(\gamma V_1, \gamma V_2)$ déterminées de la réponse vibratoire du véhicule soumis efforts extérieurs Fext et couplé au passager.

La détermination de la seconde réponse vibratoire du véhicule est obtenue à partir d'une combinaison linéaire de Nj réponses vibratoires $\gamma V_{2j}$ prise sur chacun des Nj degrés de liberté de l'interface véhicule/passager et de l'accélération interfaciale du passager de la manière suivante

$$(\gamma V_2) = \sum_{j=1}^{j=N_j} \gamma V_{2j} * (\gamma'_x)_j$$

avec $(\gamma'_x)_j$ l'accélération interfaciale sur le degré de liberté j du passager obtenue au cours de l'étape DET1).

Les réponses vibratoires $\gamma V_{2j}$ de points d'intérêt du véhicule correspondent au véhicule seul soumis à une accélération $\gamma_j$ interfaciale unitaire imposée sur le degré de liberté d'interface j de l'interface véhicule/passager et nulle sur les autres degrés de liberté, Nj étant le nombre de degrés de liberté de l'interface véhicule/passager.

Le procédé comprend une étape DET01) de détermination, à partir d'un modèle mécanique d'un passager de référence et d'un modèle mécanique d'un véhicule, d'un champ accélérométrique de référence à l'interface du passager de référence couplé audit véhicule soumis aux efforts extérieurs Fext.

L'étape DET4 consiste à sommer les première et seconde réponses vibratoires.

L'invention concerne également, selon un deuxième aspect, une unité de traitement configurée pour mettre en oeuvre un procédé selon l'invention.

L'utilisation d'une approche directe permet de supprimer les singularités.

PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :

- les figures 1a et 1b illustrent un système couplé passager/véhicule ;
- la figure 2 illustre des étapes d'un procédé selon l'invention ;
- la figure 3 illustre des courbes validant l'invention.

Sur l'ensemble des figures les éléments similaires portent des références identiques.

DESCRIPTION DETAILLEE DE L'INVENTION

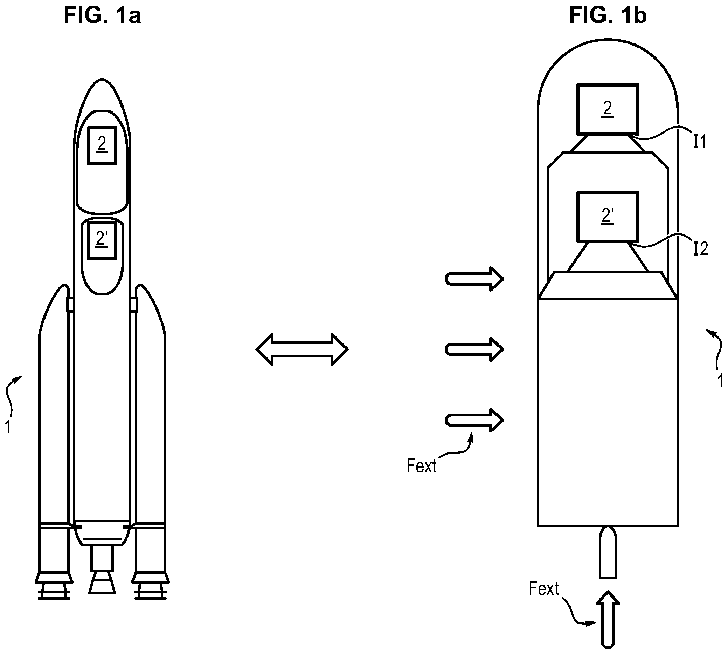

Les **figures 1a** et **1b** illustrent un système couplé véhicule/passager(s). Le « véhicule » est un lanceur 1.

On entend par « passager » les charges utiles 2, 2' haute et basse des figures 1a et 1b.

Sur ces figures x=2 charges utiles sont représentées ; elles constituent le passager. Bien entendu ce qui va être décrit s'étend à N charges utiles à interface rigide (la liaison entre la charge utile et le véhicule se fait en un seul point à 6 degrés de liberté) ou souple (la liaison entre la charge utile et le véhicule se fait en plusieurs points à 6 degrés de liberté). En effet, la notion de passager doit être considérée au sens large : sous ensemble mécanique (joint ou disjoint) relié au véhicule par une interface I1, I2...IN. Bien entendu, l'interface peut être quelconque. En pratique, pour un satellite, cette interface est constituée par la liaison adaptateur/charge utile.

On considère que le véhicule est soumis à des efforts extérieurs Fext. On précise que l'on entend par efforts extérieurs Fext les efforts répartis (aérodynamique, rafale, buffeting, onde de souffle, ...) et les efforts ponctuels (poussées, allumages, extinctions, séparations ...). On note que les efforts extérieurs Fext ne s'appliquent que sur le véhicule.

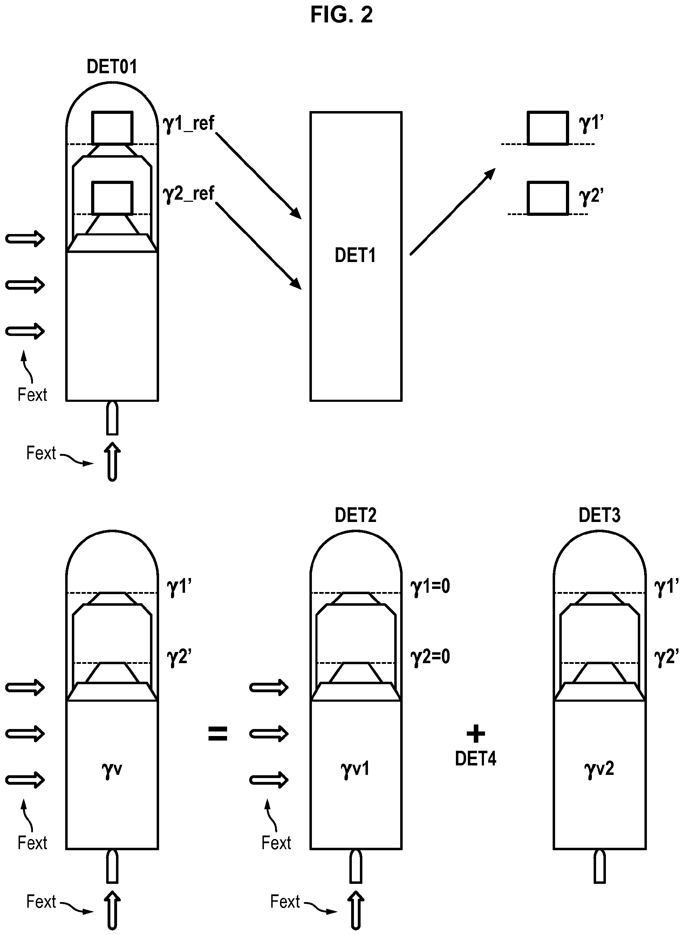

En relation avec la **figure 2** un procédé de caractérisation d'un système couplé véhicule/passager va être décrit. Un tel procédé est mis en oeuvre dans une unité de traitement (non représentée).

On considère la configuration de référence illustrée sur la figure 2 et déterminée dans une étape préliminaire DET01.

Selon cette configuration de référence, le système couplé véhicule/passager de référence est soumis aux efforts extérieurs Fext.

L'application des efforts extérieurs Fext sur le véhicule conduit au champ d'accélération de référence ($\gamma_{1\_ref}, \gamma_{2\_ref}$), il s'agit de l'accélération interfaciale c'est-à-dire le vecteur d'accélération défini sur tous les degrés de liberté de l'interface véhicule/passager.

Le champ d'accélération de référence ($\gamma_{1\_ref}, \gamma_{2\_ref}$) à l'interface véhicule/passager est déterminé au moyen de méthodes directes ou modales dans le domaine temporel ou fréquentiel (O.C. Zienkiewicz, « The Finite Element Method : Its Basis and Fundamentals », Elsevier, 7th édition, 2013). En tout état de cause, à l'issue de l'étape préliminaire DET01, le champ d'accélération de référence ($\gamma_{1\_ref}, \gamma_{2\_ref}$) est exprimé dans le domaine fréquentiel. Si la référence est dans le domaine temporel, il est possible de l'exprimer dans le domaine fréquentiel au moyen d'une transformée de Fourier (FFT).

L'objectif du procédé est de réutiliser les résultats obtenus pour la configuration de référence afin de déterminer pour de nouveaux passagers leur ambiance vibratoire mais aussi celle du véhicule en présence de ces nouveaux passagers. Une fois les nouveaux résultats obtenus, si nécessaire, il sera possible de les exprimer dans le domaine temporel au moyen d'une transformée de Fourier inverse (FFT$^{-1}$).

Dans une première étape DET1, à partir des résultats obtenus sur la configuration de référence présentée ci-dessus, on détermine au moyen d'une méthode de réanalyse, du type MORAND avec une approche directe, l'ambiance vibratoire des nouveaux passagers, il s'agit du champ d'accélération ($\gamma_1', \gamma_2'$) de la figure 2.

La méthode de MORAND repose sur l'existence d'un champ de force équivalent $F^*(\omega)$ défini à l'interface passager qui ne dépend que des caractéristiques dynamiques du véhicule et des efforts extérieurs Fext. Ce champ de force équivalent est donc strictement identique pour le système avec le passager de référence et les autres passagers à étudier.

Ce champ d'accélération ($\gamma_1', \gamma_2'$) selon la méthode de MORAND est obtenu au moyen de la relation suivante :

$$\gamma_x'(\omega) = \left\{ I + M_{REF}^{TOT^{-1}}(\omega)\Delta M_x^P(\omega) \right\}^{-1} . \gamma_{x\_ref}(\omega) \quad \text{Eq. (0)}$$

avec

- x={1, 2} mais dépend du nombre de passagers considéré (de 1 à N) ;
- $\gamma_{xref}(\omega)$ : vecteur des accélérations sur tous les degrés de liberté de l'interface véhicule/passager pour le passager de référence ;
- $\gamma_x'(\omega)$ : vecteur des accélérations sur tous les degrés de liberté de l'interface véhicule/passager pour le nouveau passager ;

$$\Delta M_x^P(\omega) = M_x^P(\omega) - M_{ref}^P(\omega) \; ;$$

- $M_x^P(\omega)$ : l'opérateur de masse dynamique d'interface du nouveau passager ;
- $M_{ref}^P(\omega)$ : l'opérateur de masse dynamique d'interface du passager de référence (celui-ci peut être nul) ;
- $M_{REF}^{TOT}(\omega)$ : l'opérateur de masse dynamique d'interface du véhicule couplé au passager de référence ;
- $I$ : la matrice identité.

Contrairement à la méthode originelle de MORAND, le Demandeur propose de ne pas calculer les opérateurs utilisés dans la méthode de MORAND en utilisant une projection sur une base modale classique mais de manière directe.

La projection tronquée a pour effet de diminuer la dimension du système de référence et conduit, par la suite, à des matrices singulières.

Aussi, pour pallier ces singularités, les opérateurs sont calculés en utilisant une approche directe avec les matrices telles qu'assemblées. On note toutefois que l'approche directe n'a que peu de conséquence sur le temps de calcul puisque les opérateurs concernés ne sont calculés qu'une fois et que cela évite le calcul d'une base modale. Le gain en temps de cette méthode résulte de la taille du système à résoudre pour un nouveau passager : le nombre de degrés de liberté de l'interface véhicule/passager.

De manière plus précise, en considérant un modèle numérique discrétisé dans le domaine fréquentiel de la forme :

$$-\omega^2 [M]\{X\} + j\omega [C]\{X\} + [K]\{X\} + j[K]\{X\} = \{F\} \quad \text{Eq. (1)}$$

avec : [M] matrice de masse du passager de référence, d'un nouveau passager ou du véhicule couplé au passager de référence, [C] matrice d'amortissement visqueux du passager de référence, d'un nouveau passager ou du véhicule couplé au passager de référence, [K] matrice de rigidité du passager de référence, d'un nouveau passager ou du véhicule couplé au passager de référence et [H] matrice d'amortissement hystérétique du passager de référence, d'un nouveau passager ou du véhicule couplé au passager de référence.

Les différents degrés de liberté du système mécanique considéré sont partitionnés en degrés de liberté interne (i) et en degrés de liberté physiques d'interface (j). On a alors :

$$\{X\} = \begin{Bmatrix} X_j \\ X_i \end{Bmatrix} \quad \text{Eq. (2)}$$

Le modèle précédent s'exprime alors de la manière suivante :

$$-\omega^2 \begin{bmatrix} M_{jj} & M_{ji} \\ M_{ij} & M_{ii} \end{bmatrix} \begin{Bmatrix} X_j \\ X_i \end{Bmatrix} + j\omega \begin{bmatrix} C_{jj} & C_{ji} \\ C_{ij} & C_{ii} \end{bmatrix} \begin{Bmatrix} X_j \\ X_i \end{Bmatrix} + \begin{bmatrix} K_{jj} & K_{ji} \\ K_{ij} & K_{ii} \end{bmatrix} \begin{Bmatrix} X_j \\ X_i \end{Bmatrix} + j \begin{bmatrix} H_{jj} & H_{ji} \\ H_{ij} & H_{ii} \end{bmatrix} \begin{Bmatrix} X_j \\ X_i \end{Bmatrix} = \begin{Bmatrix} F_j \\ 0 \end{Bmatrix}$$

$$\text{Eq. (3)}$$

En considérant des efforts ne s'appliquant que sur les degrés de liberté d'interface, la seconde ligne de l'équation ci-dessus conduit à :

$$-\omega^2 M_{ij} X_j - \omega^2 M_{ii} X_i + j\omega C_{ij} X_j + j\omega C_{ii} X_i + K_{ij} X_j + K_{ii} X_i + j H_{ij} X_j + j H_{ii} X_i = 0$$

Soit :

$$X_i = (-\omega^2 M_{ii} + j\omega C_{ii} + K_{ii} + j H_{ii})^{-1} (\omega^2 M_{ij} - j\omega C_{ij} - K_{ij} - j H_{ij}) X_j \quad \text{Eq.(4)}$$

La première ligne de l'équation (3) conduit à :

$$(-\omega^2 M_{jj} + j\omega C_{jj} + K_{jj} + j H_{jj}) X_j + (-\omega^2 M_{ji} + j\omega C_{ji} + K_{ji} + j H_{ji}) X_i = F_j \quad \text{Eq. (5)}$$

Et en utilisant l'équation (4) :

$$\{(-\omega^2 M_{jj} + j\omega C_{jj} + K_{jj} + j H_{jj}) + (-\omega^2 M_{ji} + j\omega C_{ji} + K_{ji} + j H_{ji})(-\omega^2 M_{ii} + j\omega C_{ii} + K_{ii} + j H_{ii})^{-1} (\omega^2 M_{ij} - j\omega C_{ij} - K_{ij} - j H_{ij})\} X_j = F_j$$

ou bien

$$\{(-\omega^2 M_{jj} + j\omega C_{jj} + K_{jj} + j H_{jj}) + (-\omega^2 M_{ji} + j\omega C_{ji} + K_{ji} + j H_{ji})(-\omega^2 M_{ii} + j\omega C_{ii} + K_{ii} + j H_{ii})^{-1} (\omega^2 M_{ij} - j\omega C_{ij} - K_{ij} - j H_{ij})\} \frac{1}{-\omega^2} \ddot{X}_j = F_j$$

Cette équation est de la forme $F_j = M(\omega)\gamma_j$. Elle relie les accélérations et les efforts externes aux interfaces du système grâce à l'opérateur de masse dynamique d'interface $M(\omega)$.

On obtient donc $M(\omega) =$

$$\frac{1}{-\omega^2}\left\{\begin{array}{c}(-\omega^2 M_{jj} + j\omega C_{jj} + K_{jj} + jH_{jj}) + \\ (-\omega^2 M_{ji} + j\omega C_{ji} + K_{ji} + jH_{ji})(-\omega^2 M_{ii} + j\omega C_{ii} + K_{ii} + jH_{ii})^{-1}(\omega^2 M_{ij} + j\omega C_{ij} + K_{ij} + jH_{ij})\end{array}\right\}$$

Eq. (6)

C'est l'équation (6) qui est utilisée pour déterminer directement tous les opérateurs de masse dynamique de l'équation (0).

Selon la méthode de MORAND bien que le champ de force $F^*(\omega)$ équivalent soit strictement identique pour le système avec le passager de référence et les autres passagers à étudier, ce champ de force équivalent $F^*(\omega)$ ne garantit l'équivalence qu'au niveau de l'interface passager. Il en résulte que les réponses vibratoires sont exactes au niveau des passagers mais pas à l'intérieur du véhicule.

Pour lever cette limitation, il est possible d'utiliser le principe de superposition tel qu'illustré sur la figure 2.

Selon cette décomposition :

- le premier terme de droite correspond à la réponse du véhicule seul ($\gamma V1$) soumis aux efforts extérieurs Fext, l'interface véhicule/passager étant encastrée (les accélérations sont nulles) ;
- le second terme de droite correspond à la réponse du véhicule seul (yv2) soumis au champ d'accélération d'interface ( $\gamma'_1, \gamma'_2$ ) du nouveau passager déterminé à l'étape DET1.

On constate avantageusement que le premier terme ne dépend pas des passagers.

Ainsi, pour obtenir la réponse du véhicule $\gamma V$ soumis aux efforts extérieurs Fext en présence d'un nouveau passager, il convient de procéder à deux calculs séparés :

- un calcul (étape DET2) d'une première réponse ($\gamma V1$) du véhicule seul soumis aux efforts extérieurs Fext, l'interface véhicule/passager étant encastrée ;
- un calcul (étape DET3) de réponse ($\gamma V2$) du véhicule seul soumis au champ d'accélération d'interface ( $\gamma'_1, \gamma'_2$ ) du nouveau passager.

Une fois obtenues les réponses ($\gamma V1$) et ($\gamma V2$) il suffit de les sommer (étape DET4) pour obtenir la réponse du véhicule recherchée $yV$.

L'étape DET1 de réanalyse selon la méthode de MORAND avec une approche directe est rapide mais le calcul de l'étape DET3 est plus lourd car il doit être effectué pour chaque nouveau passager. C'est en effet un calcul de réponse classique qui rend cette méthode de réanalyse sans intérêt si l'on désire obtenir des réponses sur le véhicule.

De manière avantageuse afin d'optimiser le calcul à l'étape DET3, le Demandeur a mis en évidence qu'au niveau de l'interface véhicule/passager le nombre de degrés de liberté Nj est très inférieur au nombre de configurations Np relative à un passager. Ainsi, on a Nj<<Np.

En outre, on considère l'application d'une accélération $\gamma_j$ interfaciale unitaire imposée sur le degré de liberté d'interface j de l'interface véhicule/passager et nulle sur les autres qui conduit aux champs de réponse ( $\gamma V_{2j}$ ) au niveau de plusieurs points d'intérêts à l'intérieur du véhicule. Il y a Nj réponses de ce type, Nj étant le nombre de degrés de liberté de l'interface véhicule/passager.

La détermination de ($\gamma V_1$) et des Nj ( $\gamma V_{2j}$) peut être réalisée durant la phase préliminaire DET01 puisque ces réponses ne dépendent pas du nouveau passager.

De cette façon, l'étape DET3 est réalisée en déterminant la réponse du véhicule (yv2) à partir d'une combinaison linéaire des Nj réponses vibratoires ( $\gamma V_{2j}$) et de l'accélération interfaciale ( $\gamma'_1, \gamma'_2$ ) du passager déterminée à l'étape DET1. La combinaison linéaire est définie comme suit : $(\gamma V_2) = \sum_{j=1}^{j=N_j} \gamma V_{2j} * (\gamma'_1, \gamma'_2)_j$ .

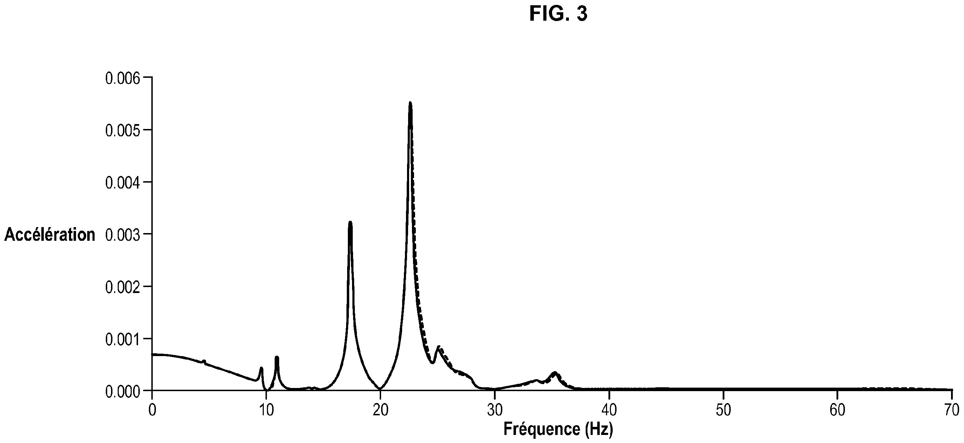

La méthode de l'invention a été implémentée et testée. La figure 3 illustre le résultat de ces tests.

La courbe en trait plein représente dans le domaine fréquentiel la réponse dynamique à l'interface véhicule/passager calculée selon la méthode classique et la courbe en pointillés représente la réponse dynamique à l'interface véhicule/passager calculée selon la méthode de l'invention (MORAND avec approche directe).

On remarque immédiatement que ces courbes sont identiques ce qui valide la méthode de l'invention.

En outre, le temps de calcul pour obtenir cette réponse selon la méthode classique est d'environ 30 minutes alors qu'avec la méthode de l'invention le temps de calcul est d'environ 20s. Le gain de temps est considérable.

**Revendications**

1. Procédé mis en oeuvre par ordinateur, pour le contrôle d'une compatibilité mécanique entre un passager et un véhicule par la détermination, par réanalyse, d'une ambiance vibratoire d'un système couplé comprenant le véhicule et le passager, le véhicule étant soumis à des efforts extérieurs Fext et étant couplé à un passager comprenant x=1,..., N charge(s) utile(s), la dite ambiance vibratoire étant **caractérisée par** des accélérations interfaciales au niveau d'interfaces Ix véhicule/passager,

    le procédé étant **caractérisé en ce qu'**il comprend une étape DET1) de détermination, à partir des accélération(s) interfaciale(s) $\gamma_{x\_ref}$ de référence d'un passager de référence, d'accélération(s) interfaciale(s) $\gamma'_x$ relatives à un nouveau passager au moyen de la relation suivante

$$\gamma'_x(\omega) = \left\{ I + M_{REF}^{TOT^{-1}}(\omega)\Delta M_x^P(\omega) \right\}^{-1} . \gamma_{x\_ref}(\omega)$$

    avec

    - $\gamma_{xref}(\omega)$ : vecteur des accélérations sur tous les degrés de liberté de l'interface véhicule/passager pour le passager de référence ;
    - $\gamma'_x(\omega)$ : vecteur des accélérations sur tous les degrés de liberté de l'interface véhicule/passager pour le nouveau passager ;

$$\Delta M_x^P(\omega) = M_x^P(\omega) - M_{ref}^P(\omega) \; ;$$

    - $M_x^P(\omega)$ : l'opérateur de masse dynamique d'interface du nouveau passager ;
    - $M_{ref}^P(\omega)$ : l'opérateur de masse dynamique d'interface du passager de référence ;
    - $M_{REF}^{TOT}(\omega)$ : l'opérateur de masse dynamique d'interface du véhicule couplé au passager de référence ;

    les opérateurs $M_x^P(\omega)$, $M_{ref}^P(\omega)$ et $M_{REF}^{TOT}(\omega)$ étant obtenus par une approche directe de la manière suivante :

$$M(\omega)=$$
$$\frac{1}{-\omega^2}\left\{ \begin{array}{c} (-\omega^2 M_{jj} + j\omega C_{jj} + K_{jj} + jH_{jj}) + \\ (-\omega^2 M_{ji} + j\omega C_{ji} + K_{ji} + jH_{ji})(-\omega^2 M_{ii} + j\omega C_{ii} + K_{ii} + jH_{ii})^{-1}(\omega^2 M_{ij} + j\omega C_{ij} + K_{ij} + jH_{ij}) \end{array} \right\}$$

    - M matrice de masse du passager de référence, du nouveau passager ou du véhicule couplé au passager de référence ;
    - K matrice de rigidité du passager de référence, du nouveau passager ou du véhicule couplé au passager de référence ;
    - C matrice d'amortissement visqueux du passager de référence, du nouveau passager ou du véhicule couplé au passager de référence ;
    - H matrice de d'amortissement hystérétique du passager de référence, du nouveau passager ou du véhicule couplé au passager de référence ;
    - *I* : la matrice identité.

2. Procédé selon la revendication 1, comprenant en outre les étapes suivantes DET2) détermination d'une première réponse vibratoire ($\gamma V_1$) du véhicule seul, encastré sur tous les degrés de libertés de l'interface véhicule/passager et soumis aux efforts extérieurs Fext ;

DET3) détermination d'une seconde réponse vibratoire $\gamma V_2$ du véhicule soumis à l'accélération interfaciale ( $\gamma_1', \gamma_2'$ ) du nouveau passager ;

DET4) détermination à partir, des première et seconde réponses vibratoires ($\gamma V_1$, $\gamma V_2$) déterminées de la réponse vibratoire ($\gamma V$) du véhicule soumis efforts extérieurs Fext et couplé au nouveau passager.

3. Procédé selon la revendication 2, dans lequel la détermination de la seconde réponse vibratoire du véhicule est obtenue à partir d'une combinaison linéaire de Nj réponses vibratoires $\gamma V_{2j}$ prise sur chacun des Nj degrés de liberté de l'interface véhicule/passager et de l'accélération interfaciale du nouveau passager de la manière suivante

$$(\gamma V_2) = \sum_{j=1}^{j=N_j} \gamma V_{2j} * (\gamma_x')_j$$

avec $(\gamma_x')_j$ l'accélération interfaciale sur le degré de liberté j du nouveau passager obtenue au cours de l'étape DET1).

4. Procédé selon la revendication 3, dans lequel les réponses vibratoires $\gamma V_{2j}$ de points d'intérêt du véhicule correspondent au véhicule seul soumis à une accélération $\gamma_j$ interfaciale unitaire imposée sur le degré de liberté d'interface j de l'interface véhicule/passager et nulle sur les autres degrés de liberté, Nj étant le nombre de degrés de liberté de l'interface véhicule/passager.

5. Procédé selon l'une des revendications précédentes, comprenant une étape DET01 de détermination, à partir d'un modèle mécanique d'un passager de référence et d'un modèle mécanique d'un véhicule, d'un champ accélérométrique de référence ($\gamma_{1\_ref}$, $\gamma_{2\_ref}$) à l'interface du passager de référence couplé audit véhicule soumis aux efforts extérieurs Fext.

6. Procédé d'analyse selon l'une des revendications 2 à 4, dans lequel l'étape DET4 consiste à sommer les première et seconde réponses vibratoires.

7. Unité de traitement comprenant un processeur configuré pour mettre en oeuvre un procédé selon l'une des revendications précédentes.

**Patentansprüche**

1. Computergestütztes Verfahren zur Kontrolle einer mechanischen Kompatibilität zwischen einem Insassen und einem Fahrzeug durch die Bestimmung, durch Reanalyse, eines Schwingungsumfelds eines gekoppelten Systems, das das Fahrzeug und den Insassen umfasst, wobei das Fahrzeug externen Belastungen, Fext, ausgesetzt ist und mit einem Insassen gekoppelt ist, der x=1,..., N Nutzlast(en) umfasst, wobei das Schwingungsumfeld durch Grenzflächenbeschleunigungen im Bereich der Fahrzeug/Insassen-Schnittstellen Ix gekennzeichnet ist,

wobei das Verfahren **dadurch gekennzeichnet ist, dass** es einen Bestimmungsschritt DET1) umfasst, ausgehend von der bzw. den Referenz-Grenzflächenbeschleunigung(en) $\gamma_{x\_ref}$ eines Referenzinsassens, und Grenzflächenbeschleunigung(en) $\gamma_x'$ in Bezug auf einen neuen Insassen, mittels der folgenden Relation:

$$\gamma_x'(\omega) = \left\{ I + M_{REF}^{TOT^{-1}}(\omega) \Delta M_x^P(\omega) \right\}^{-1} . \gamma_{x\_ref}(\omega)$$

mit:

- $\gamma_{xref}(\omega)$: Vektor der Beschleunigungen über alle Freiheitsgrade der Fahrzeug/Insassen-Schnittstelle für den Referenzinsassen;
- $\gamma_x'(\omega)$: Vektor der Beschleunigungen über alle Freiheitsgrade der Fahrzeug/Insassen-Schnittstelle für den neuen Insassen;

$$\Delta M_x^P(\omega) = M_x^P(\omega) - M_{ref}^P(\omega);$$

- $M_x^P(\omega)$ Operator der dynamischen Masse der Schnittstelle des neuen Insassens;

- $M_{ref}^P(\omega)$ : Operator der dynamischen Masse der Schnittstelle des Referenzinsassens;

- $M_{REF}^{TOT}(\omega)$: : Operator der dynamischen Masse der Fahrzeugschnittstelle, die mit dem Referenzinsassen gekoppelt ist;

wobei die Operatoren $M_x^P(\omega)$, $M_{ref}^P(\omega)$ und $M_{REF}^{TOT}(\omega)$ durch einen direkten Ansatz auf folgende Weise erhalten werden:

$$M(\omega) = \frac{1}{-\omega^2}\left\{ \begin{array}{l} (-\omega^2 M_{jj} + j\omega C_{jj} + K_{jj} + jH_{jj}) + \\ (-\omega^2 M_{ji} + j\omega C_{ji} + K_{ji} + jH_{ji})(-\omega^2 M_{ii} + j\omega C_{ii} + K_{ii} + jH_{ii})^{-1}(\omega^2 M_{ij} + j\omega C_{ij} + K_{ij} + jH_{ij}) \end{array} \right\}$$

- M Massenmatrix des Referenzinsassens, des neuen Insassens oder des mit dem Referenzinsassen gekoppelten Fahrzeugs;
- K Steifigkeitsmatrix des Referenzinsassens, des neuen Insassens oder des mit dem Referenzinsassen gekoppelten Fahrzeugs;
- C Matrix der viskosen Dämpfung des Referenzinsassens, des neuen Insassens oder des mit dem Referenzinsassen gekoppelten Fahrzeugs;
- H Matrix der hysteretischen Dämpfung des Referenzinsassens, des neuen Insassens oder des mit dem Referenzinsassen gekoppelten Fahrzeugs;
- I: die Identitätsmatrix.

2. Verfahren nach Anspruch 1, ferner die folgenden Schritte umfassend

DET2) Bestimmung einer ersten Schwingungsreaktion $(\gamma V_1)$ des Fahrzeugs allein, eingebettet in alle Freiheitsgrade der Fahrzeug/Insassen-Schnittstelle und den externen Belastungen, Fext, ausgesetzt;
DET3) Bestimmung einer zweiten Schwingungsreaktion $(\gamma V_2)$ des Fahrzeugs, das der Grenzflächenbeschleunigung $(\gamma'_1, \gamma'_2)$ des neuen Insassens ausgesetzt ist;
DET4) Bestimmung, ausgehend von der ersten und zweiten Schwingungsreaktion $(\gamma V_1, \gamma V_2)$, die aus der Schwingungsreaktion $(\gamma V)$ des Fahrzeugs bestimmt wurden, das externen Belastungen, Fext, ausgesetzt und an den neuen Insassen gekoppelt ist.

3. Verfahren nach Anspruch 2, wobei die Bestimmung der zweiten Schwingungsreaktion des Fahrzeugs ausgehend von einer linearen Kombination von NJ Schwingungsreaktionen, $\gamma V_{2j}$, erhalten wird, die an jedem der Freiheitsgrade, Nj, der Fahrzeug/Insassen-Schnittstelle und der Grenzflächenbeschleunigung des neuen Insassens auf folgende Weise gemessen werden

$$(\gamma V_2) = \sum_{j=1}^{j=N_j} \gamma V_{2j} * (\gamma'_x)_j$$

mit $(\gamma'_x)_j$ der Grenzflächenbeschleunigung über den Freiheitsgrad j des neuen Insassens, der während dem Schritt DET1) erhalten wurde.

4. Verfahren nach Anspruch 3, wobei die Schwingungsreaktionen $\gamma V_{2j}$ von Interessenpunkten des Fahrzeugs dem Fahrzeug allein entsprechen, das einer einheitlichen Grenzflächenbeschleunigung $\gamma_j$ ausgesetzt ist, die auf dem Freiheitsgrad der Schnittstelle j der Fahrzeug/Insassen-Schnittstelle auferlegt ist, und null auf den anderen Freiheitsgraden, wobei Nj die Anzahl der Freiheitsgrade der Fahrzeug/Insassen-Schnittstelle ist.

5. Verfahren nach einem der vorhergehenden Ansprüche, einen Schritt DET01) der Bestimmung umfassend, ausgehend von einem mechanischen Modell eines Referenzinsassens und einem mechanischen Modell eines Fahrzeugs, eines Referenz-Beschleunigungsfeldes $(\gamma_{1\_ref}, \gamma_{2\_ref})$ an der Schnittstelle des Referenzinsassens, die an das Fahrzeug gekoppelt ist, das externe Belastungen, Fext, ausgesetzt ist.

**6.** Analyseverfahren nach einem der Ansprüche 2 bis 4, wobei der Schritt DET4) darin besteht, die erste und die zweite Schwingungsreaktion zu summieren.

**7.** Verarbeitungseinheit, die einen Prozessor umfasst, der zum Ausführen eines Verfahrens nach einem der vorhergehenden Ansprüche konfiguriert ist.

**Claims**

**1.** A method implemented by computer, for controlling a mechanical compatibility between a passenger and a vehicle by determining, by reanalysis, a vibratory environment of a coupled system comprising the vehicle and the passenger, the vehicle being subjected to external forces Fext and being coupled to a passenger comprising x =1, ..., N load(s), said vibratory environment being **characterized by** interfacial accelerations at vehicle/passenger interfaces lx,

the method being **characterized in that** it comprises a step DET1) of determining, on the basis of the reference interfacial acceleration(s) $\gamma_{x\_ref}$ of a reference passenger, interfacial acceleration(s) $\gamma'_x$ relating to a new passenger by means of the following relationship

$$\gamma'_x(\omega) = \left\{ I + M_{REF}^{TOT^{-1}}(\omega)\Delta M_x^P(\omega) \right\}^{-1}.\gamma_{x\_ref}(\omega)$$

with

- $\gamma_{xref}(\omega)$ : vector of accelerations on all degrees of freedom of the vehicle/passenger interface for the reference passenger;

- $\gamma'_x(\omega)$ : vector of accelerations on all degrees of freedom of the vehicle/passenger interface for the new passenger;

$$\Delta M_x^P(\omega) = M_x^P(\omega) - M_{ref}^P(\omega) ;$$

- $M_x^P(\omega)$ : the dynamic mass operator of the new passenger interface;

- $M_{ref}^P(\omega)$ : the dynamic mass operator of reference passenger interface;

- $M_{REF}^{TOT}(\omega)$ : the dynamic mass operator of the vehicle coupled to the reference passenger interface;

the operators $M_x^P(\omega)$, $M_{ref}^P(\omega)$ and $M_{REF}^{TOT}(\omega)$ being obtained by a direct approach in the following manner:

$$M(\omega) =$$

$$\frac{1}{-\omega^2} \left\{ \begin{array}{c} \left(-\omega^2 M_{jj} + j\omega C_{jj} + K_{jj} + jH_{jj}\right) + \\ \left(-\omega^2 M_{ji} + j\omega C_{ji} + K_{ji} + jH_{ji}\right)\left(-\omega^2 M_{ii} + j\omega C_{ii} + K_{ii} + jH_{ii}\right)^{-1}\left(\omega^2 M_{ij} + j\omega C_{ij} + K_{ij} + jH_{ij}\right) \end{array} \right\}$$

- M mass matrix of the reference passenger, the new passenger or the vehicle coupled to the reference passenger;
- K stiffness matrix of the reference passenger, the new passenger or the vehicle coupled to the reference passenger;
- C viscous damping matrix of the reference passenger, the new passenger or the vehicle coupled to the reference passenger;

- H the hysteretic damping matrix of the reference passenger, the new passenger or the vehicle coupled to the reference passenger;
- $I$: the identity matrix.

2. The method according to claim 1, further comprising the following steps of DET2) determining a first vibratory response ($\gamma V_1$) of the vehicle alone, embedded in all degrees of freedom of the vehicle/passenger interface and subjected to the external forces Fext;

DET3) determining a second vibratory response $\gamma V_2$ of the vehicle subjected to the interfacial acceleration ($\gamma_1',\ \gamma_2'$) of the new passenger;

DET4) determining from, first and second vibratory responses ($\gamma V_1, \gamma V_2$) determined from the vibratory response ($\gamma V$) of the vehicle subjected to external forces Fext and coupled to the new passenger.

3. The method according to claim 2, wherein the determination of the second vibratory response of the vehicle is obtained from a linear combination of Nj vibratory responses $\gamma V_{2j}$ taken on each of the Nj degrees of freedom of the vehicle/passenger interface and the interfacial acceleration of the passenger as follows

$$(\gamma V_2) = \sum_{j=1}^{j=N_j} \gamma V_{2j} * (\gamma_x')_j$$

with $(\gamma_x')_j$ the interfacial acceleration on the degree of freedom j of the passenger obtained during the step DET1).

4. The method according to claim 3, wherein the vibratory responses $\gamma V_{2j}$ of points of interest of the vehicle correspond to the vehicle alone subjected to a unitary interfacial acceleration $\gamma_j$ imposed on the interface degree of freedom j of the vehicle/passenger interface and equal to zero on the other degrees of freedom, Nj being the number of degrees of freedom of the vehicle/passenger interface.

5. The method according to any of the preceding claims, comprising a step DET01) of determining, from a mechanical model of a reference passenger and a mechanical model of a vehicle, a reference accelerometric field ($\gamma_{1\_ref}, \gamma_{2\_ref}$) at the interface of the reference passenger coupled to said vehicle, subjected to external forces Fext.

6. An analysis method according to any of claims 2 to 4, wherein the step DET4 consists of summing the first and second vibratory responses.

7. A processing unit comprising a processor configured to implement a method according to any of the preceding claims.

**FIG. 1a**

**FIG. 1b**

I1

I2

2

2'

Fext

Fext

1

1

EP 3 596 622 B1

# FIG. 2

**FIG. 3**

EP 3 596 622 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **P.A. BLELLOCH ; C.C. FLANIGAN.** A time domain approach for spacecraft reanalysis. *AIAA journal*
- Identification paramétrique de grandes structures : réanalyse et méthode évolutionnaire. **CHRISTOPHE BERTHOD.** Mécanique [physics.med-ph. Université de Franche-Comté, 1998
- **H. J.-P. MORAND et al.** Prévision de l'ambiance vibratoire des satellites. *Tendances actuelles en calcul de structures, Bastia,* 06 Novembre 1985
- **MORAND H J P ; LE GOARANT M ; BODAGALA P R ; CHEMOUL B.** *Prévision de l'ambiance vibratoire des satellites,* 1985
- **SCHOTTE JEAN-SEBASTIEN ; MIRAS AND ROGER OHAYON.** *Effect of internal liquids on the vibrations of aerospace structures,* 14 Juin 2012
- **YUAN ZHAO XU ; YU KAI PING.** *Finite element model updating of damped structures using vibration test data under base excitation,* 19 Décembre 2014
- **O.C. ZIENKIEWICZ.** The Finite Element Method : Its Basis and Fundamentals. Elsevier, 2013